Europäisches Patentamt

(19) European Patent Office

Office européen des brevets

(11) Publication number : **0 216 933 B1**

# EUROPEAN PATENT SPECIFICATION

(12)

(45) Date of publication of patent specification :
31.07.91 Bulletin 91/31

(51) Int. Cl.⁵ : **H01L 21/316, H01L 21/268**

(21) Application number : 86901517.2

(22) Date of filing : 28.02.86

(86) International application number :
PCT/JP86/00103

(87) International publication number :
WO 86/05320 12.09.86 Gazette 86/20

(54) **METHOD FOR FABRICATING AN INSULATING OXIDE LAYER ON SEMICONDUCTOR SUBSTRATE SURFACE.**

(30) Priority : 28.02.85 JP 40175/85
28.02.85 JP 40176/85
28.02.85 JP 40177/85

(43) Date of publication of application :
08.04.87 Bulletin 87/15

(45) Publication of the grant of the patent :
31.07.91 Bulletin 91/31

(84) Designated Contracting States :
DE FR GB NL

(56) References cited :
EP-A- 0 162 711
DE-A- 3 416 470
FR-A- 2 517 121
Applied Physics Letters, vol. 42, no. 8, April 1983 (New York, US) I. Boyd: "Laser enhanced oxidation of Sl.", pages 728-730, see figure 1; page 728, column 1, paragraph 2 - page 730, column 2, paragraphs 1, 2
Applied Physics Letters, vol. 38, no. 12, June 1981 (New York, US) Y.S. Liu et al.: "Rapid oxidation via adsorption of oxygen in laser-induced amorphous Silicon" pages 1005-1007, see page 1005, column 1,paragraphs 2, 3; page 1006, column 2, paragraph 2
Patents Abstract of Japan, vol. 5, no. 167, 14 October 1980 page 839
Applied Physics Letters, vol. 45, no. 3, August 1984 (New York, US) T.E. Orlowski et al.: "Ultrafast laser-induced oxidation of Silicon: an new approach towards high quality, low temperature, patterned SiO2 formation", pages 241-243, see page 241, column 1, paragraph 2; page 241, column 2, paragraph 2 - page 242, column 1, paragraph 1

(56) References cited :
Japanese Journal of Applied Physics Supplements 16th Conference solid State Devices and Materials(1984) Tokyo (JP) K. Morioka et al.: " XeCl excimerlaser oxidation of Si employing 02/Cl2 gas mixture", page 50 see the entire document

(73) Proprietor : SONY CORPORATION
7-35 Kitashinagawa 6-Chome Shinagawa-ku Tokyo 141 (JP)

(72) Inventor : SAMESHIMA Toshiyuki Sony Corporation
7-35, Kitashinagawa 6-chome Shinagawa-ku Tokyo 141 (JP)
Inventor : USUI, Setsuo Sony Corporation
7-35, Kitashinagawa 6-chome Shinagawa-ku Tokyo 141 (JP)

(74) Representative : TER MEER - MÜLLER - STEINMEISTER & PARTNER
Mauerkircherstrasse 45
W-8000 München 80 (DE)

## Description

The present invention relates to a method for producing an insulating oxide layer on a semiconductor substrate.

I. W. Boyd in Applied Physics Letters, Vol. 42, No. 8, 15 April 1983, pages 728 - 730 describes such a method. A semiconductor substrate of Si is heated by the light of a laser beam in an $O_2$ gas atmosphere inside a reaction chamber.

FR-A-2 517 121 describes a method according to which a semiconductor substrate is heated inside a reaction chamber by a resistance heater. The chamber contains an oxidizing gas consisting of $N_2O$ or $O_2$ or $NO_2$. The gas is irradiated with light inducing the formation of atomic oxygen. Besides atomic oxygen, $O_3$ may be formed by reaction of atomic oxygen with molecular oxygen.

DE-A-34 16 470 describes a general method for providing layers on semiconductor substrates. A reactive gas is irradiated by a first light source, and the substrate is irradiated by a second light source. The irradiated gas flows along the surface of the substrate. Due to activation of the gas by light and due to the heating of the substrate, the formation of a layer on the substrate is especially effective.

It is the object of the present invention to provide an effective method for fabricating an insulating oxide layer on the surface of a semiconductor.

The method according to the present invention comprises the steps as outlined in Claim 1.

This method is similar to the method as described in FR-A-2 517 121, however, with the difference that the oxidizing gas filled into the reaction chamber already contains $O_3$. An oxidizing gas containing a mixture of $O_3$ and $O_2$ is highly reactive. There exists a wide range of lasers emitting light with wavelenths being well absorbed by $O_3$.

The first energy beam to heat the semiconductor substrate is preferably selected from among XeCl excimer laser beams, Ar laser beams, XeF excimer laser beams, KrF excimer laser beams, ArF excimer laser beams, ruby laser beams, YAG laser beams, low-pressure mercury lamp light beams, electron beams, or ion beams.

The invention will now be described in several embodiments illustrated by figures. These figures show :

Fig. 1 is a fragmentary illustration of the first embodiment of an insulating layer fabricating device according to the present invention ;

Fig. 2 shows the absorption spectrum of an XeCl excimer laser beam in both $O_2$ and an $O_3/O_2$ mixture employed in the first emnbodiment of the device ;

Fig. 3 is a fragmentary illustration of the second embodiment of an insulating-layer-fabricating device according to the invention

Fig. 4 shows the relationship between the wavelength of the energy beam employed in the foregoing second and third embodiments, and the occurence of photolysis according to the gaseous reagent in the device ;

Fig. 5 shows the relationship between the absorptance and the wavelength of the energy beam ;

Fig. 6 shows relationship between quantum efficiency and the wavelength of the energy beam ; and

Figs. 7 to 9 are fragmentary illustrations of examples of simplifications of the device according to the second and third embodiments

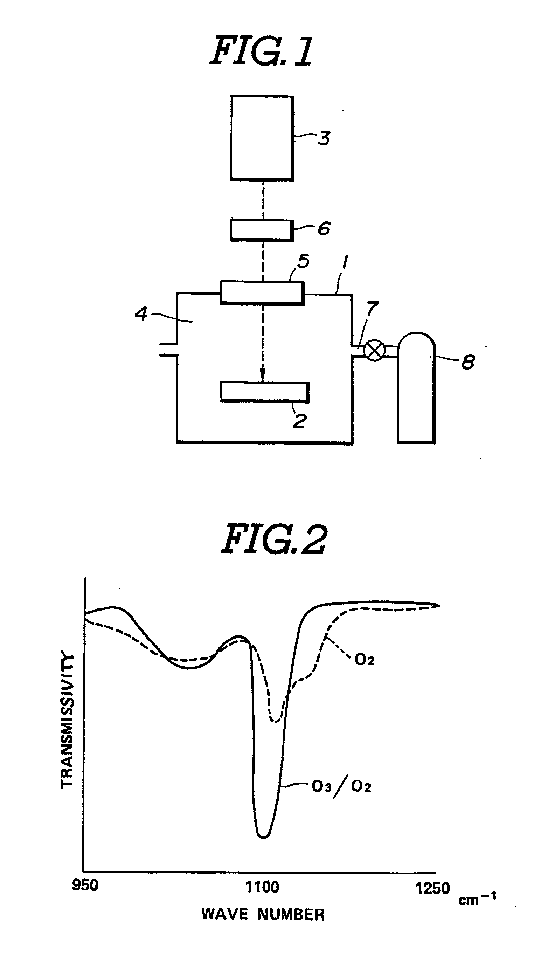

Referring now to the drawings, particularly to Fig. 1, the first embodiment of an insulating-layer-fabricating device according to the present invention employs a XeCl excimer laser with a 308 nm wavelength as its energy beam. An XeCl excimer laser beam irradiates a semiconductor surface under a highly reactive atmosphere. In this embodiment, a mixture of ozone and oxygen is used. Preferably, the atmosphere mixture is about 0.5 atm. $(50x10^6Pa)$ of $O_2$ with 1% $O_3$.

In Fig. 1, the first embodiment of the insulating-layer-fabricating device comprises a device housing 1 defining therein a reaction chamber 4. A semiconductor substrate 2, specifically silicon, is supported within the reaction chamber 4. The reaction chamber 4 is connected to an $O_3/O_2$ mixture source 8 through a gas inlet.

The device housing 1 is sealed in part by a window 5 made of a crystal line material. The crystal window 5 opposes a lens 6 which, in turn, opposes an excimer laser 3. The XeCl excimer laser beam generated by the excimer laser generator 3 passes through the lens 6 and the crystal window 5 and impinges on the surface of the silicon substrate 2. Irradiation with the XeCl excimer laser beam heats, the surface of the silicon substrate 2 which induces the silicon atoms in the silicon substrate 2 to react with oxygen atoms in the $O_3/O_2$ mixture. Thus, a silicon oxide layer is formed on the surface of the silicon substrate 2.

In the shown first embodiment, the XeCl excimer laser generator 3 generates a XeCl excimer laser beam with laser energy of 500 mJ/cm². Ten 3.5-ns pulses are transmitted every second and a total of 8000 pulses impinge on the substrate surface.

During irradiation with the XeCl excimer laser, the substrate undergoes the following system of reactions :

$$O_3 + Si \longrightarrow SiO + O_2 \;..... \;\;(a)$$
$$SiO + O_3 \longrightarrow SiO_2 + O_2 \;..... \;\;(b)$$

The results of analysis of the silicon oxide layer formed by the first embodiment of the insulating-layer-fabricating device of Fig. 1 by infrared spectrophotometry are shown in Fig. 2.

As shown in Fig. 2. the silicon oxide layer formed by irradiation with the XeCl excimer laser beam under

an $O_3/O_2$ atmosphere exhibits the absorption sectrum shown in solid line. The absorption spectrum has a peak at a wave number of 1100 $cm^{-1}$, which approximately corresponds to the energy of the stretching mode of the silicon oxide. This compares favorably with the absorption spectrum of a silicon oxide layer formed by irradiation with a XeCl excimer laser beam under an atmosphere of pure $O_2$ gas, which is shown in broken line in Fig. 2.

As will be appreciated from Fig. 2, under the same irradiating conditions of the XeCl excimer laser beam, a thicker silicon oxide layer can be formed by irradiation under an atmosphere of an $O_3/O_2$ mixture than under an atmosphere of $O_2$ gas. In addition, as will be appreciated from Fig. 2, the peak in the absorption spectrum of the silicon oxide layer formed under an atmosphere of $O_3/O_2$ is much sharper and more regular than that of the silicon oxide layer formed under an atmosphere of $O_2$. This means that silicon oxide layers formed under the $O_3/O_2$ atmosphere will exhibit higher uniformity than those of formed under the $O_2$ atmosphere.

It should be appreciated that oxidation is induced in the preferred embodiment by irradiating the surface of the silicon substrate with a XeCl excimer laser beam which causes a thermal reaction with the highly reactive atmosphere, i.e. the $O_3/O_2$ mixture. The wavelength of the excimer laser beam should be selected in accordance with the material of the substrate. In case of a silicon substrate, the wavelength of the energy beam necessary heat the surface of the substrate is

< 1130 nm.

In addition, it is preferable to keep the energy absorption coefficient of the surface of the substrate less than $10^3$ $cm^{-1}$. In order to satisfy this absorption condition, the wavelength must be greater than 650 nm.

Energy beam need not necessarily be a XeCl excimer laser beam but can be an Ar laser beam, a XeF excimer laser beam, a KrF excimer laser beams, an ArF excimer laser beams, a ruby laser beam, a YAG laser beam or other higher harmonic laser or a low-pressure mercury lamp beam, electron beam, ion beam, or some combination thereof.

When a short-exposure laser, such as a pulsed laser is used, the pulse width must be selected in accordance with the surface temperature of the substrate and the characteristics of the reactive atmosphere in order to achieve optimal oxidation. The required pulse width can be derived from :

$2 / D \times \tau < 10$ μs,

D : thermal diffusion coefficient

$\tau$ : pulsewidth

Therefore, in the case of a silicon substrate, the pulse width of the energy beam must be shorter than 130 μs.

Reaction rate at the surface of the substrate can be controlled by the atmospheric presssure. In the case of the foregoing first embodiment, by increasing the atmosphere pressure of the $O_3$ component, or by increasing the mixture gas pressure from normal pressure to high pressure, the reaction can be accelerated.

The process for fabricating an insulating layer by irradiating onto a substrate surface with an energy beam under a highly reactive atmosphere, is also applicable to substrates with high electron mobility, such as GaAs substrates. The process according to the invention prevents generation of arsenic which otherwise tend to occur in conventional oxidation processs. The preferred process is also applicable to substrate made of Ta, Mo, Al and so forth.

It is also possible to form an insulating layer on a substrate by melting the surface of the substrate by irradiating it with an energy beam under a highly reactive atmosphere. This process accelerates formation of the insulating layer on the substrate and will be described hereafter in detail.

The insulating-layer-fabricating device of Fig. 1 can be modified to implement this modified process. The XeCl excimer laser 3 is used as the source of the energy beam. As in the above process the silicon substrate 2 is irradiated with the XeCl excimer laser beam under the $O_3/O_2$ atmosphere.

The energy needed to melt the surface of a silicon substrate, is approximately 260 $mJ/cm^2$. Considering reflection from the silicon substrate, an energy intensity of 650 $mJ/cm^2$ would be preferable. If the energy of the laser beam 1100 $mJ/cm^2$, the melting depth of the substrate would be about 340 nm. As the melting region expands the oxidation rate increases.

During melting, the silicon atoms making up the substrate react with oxygen atoms in the $O_3/O_2$ mixture to form silicon oxide. The melting of the substrate expedites coupling of the silicon atoms and oxygen atoms and so accelerates the reaction. Therefore, in comparison with the process of simply heating the substrate surface by means of the energy beam, the time required to form an insulating layer, i.e. silicon oxide layer, is decreased.

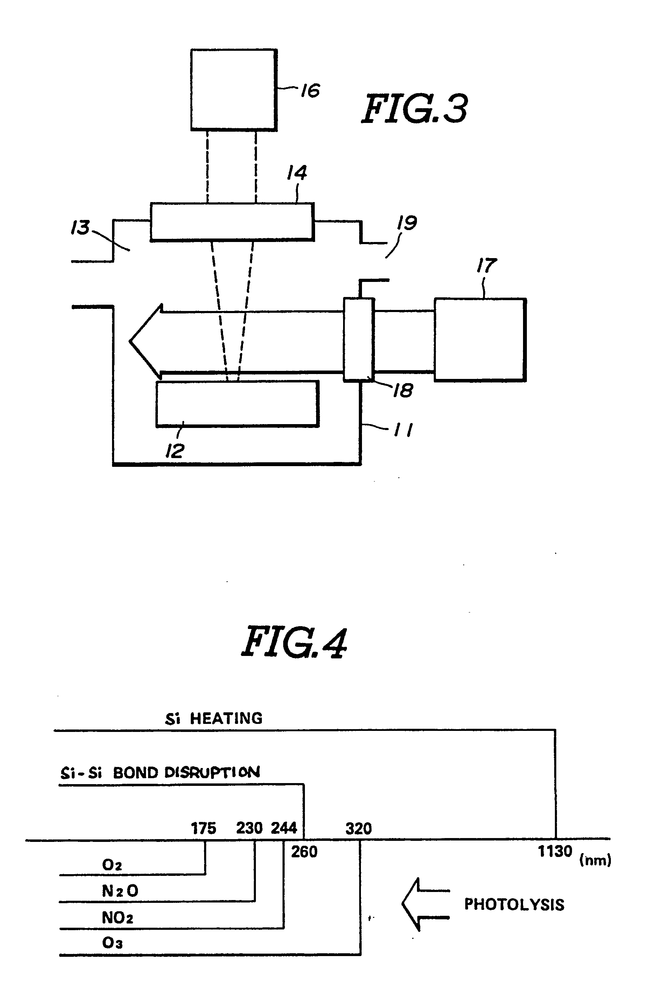

Fig. 3 shows the second embodiment of the insulating-layer-fabricating device according to the invention, which implements the preferred process for fabricating an insulating layer on a substrate.

As in the first embodiment, the device comprises a housing 11 defining therein a reaction chamber 13. A silicon substrate 12 is supported within the reaction chamber 13. The reaction chamber 13 is filled with an $O_3/O_2$ mixture, under the same conditions employed in the first embodiment through an inlet 19. The housing has crystal windows 14 and 18. The crystal window 14 is in the ceiling of the housing so as to lie essentially in parallel to the substrate 12 supported in the reaction chamber. On the other hand, the crystal window 18 is in the side wall of the housing 11 and so lies perpendicular to the substrate.

A XeF excimer laser unit 16 including a lens opposes the crystal window 14. The XeF excimer laser unit 16 generates a XeF excimer laser beam at a wavelength of 350 nm. Another XeCl excimer laser unit 17 opposes the crystal window 18. The XeCl excimer laser unit 17 generate a XeCl excimer laser beam at a wavelength of 308 nm. As seen from Fig. 3, the XeF excimer laser beam from the XeF excimer laser unit 16 impinges essentially perpendicularly to the substrate surface and the XeCl excimer laser beam from the XeCl excimer laser unit 17 is directed parallel to the substrate surface. The XeCl laser beam parallel to the substrate surface acts on the $O_3/O_2$ mixture to cause photolysis by photo-absorption. The photolysis caused $O_3$ can be illustrated by the following formula :

$$O_3 \longrightarrow O_2 + O^*$$

As a result, excited oxygen atoms $O^*$ are generated in the gas mixture. This excited oxygen atom $O^*$ is strongly oxidizing and so accelerates oxidation of the surface of the silicon substrate in the presence of the XeF excimer laser beam from the XeF excimer laser unit 16. During oxidation of the substrate surface, the XeF excimer laser beam serves to induce thermal reaction between the silicon atoms of the substrate and the excited oxygen atoms $O^*$ of the $O_3/O_2$ atmosphere.

As will be appreciated herefrom, since the XeCl excimer laser used to generate the excited oxygen atoms $O^*$ in the $O_3/O_2$ mixture is irradiated substantially parallel to the substrate surface, excited oxygen atoms $O^*$ can be generated uniformly over the entire surface of the substrate to be coated with the insulating layer. This ensures uniformity of the silicon oxide composition on the substrate surface. Also, with this arrangement, the thickness of the silicon oxide layer serving as an insulating layer can be substantially uniform.

The thickness of the insulating layer to be formed on the substrate can be adjusted by adjusting the intensities of the energy beams from the laser units 16 and 17. Also, the silicon oxide layer on the substrate surface can be formed by scanning the XeF excimer laser beam across the horizontal plane, assuming the substrate surface lies horizontally in the reaction chamber 13.

A pulsed KrF excimer laser may be used to break up silicon-silicon bonds in the substrate as a replacement for the XeF excimer laser in the former embodiment. A KrF excimer laser unit generates a pulsed KrF excimer laser beam of 249 nm wavelength. Since the bonds of the silicon atoms can be cut by laser light at wavelengths shorter than 260 nm, as is well known, the bonds between the silicon atoms in the silicon substrate 12 are broken by the KrF excimer laser beam from the KrF excimer laser unit. This greatly facilitates oxidation of the silicon atoms by coupling with oxygen atoms. This is especially true due to the effect of the XeCl excimer laser beam from the XeCl excimer laser unit 17, which generates excited oxygen atoms $O^*$.

It should be appreciated that the KrF excimer laser beam serves not only to cut the bonds between silicon atoms but also to heat the surface of the silicon substrate and so induce thermal reaction between the oxygen atoms in the atmosphere and the silicon atoms in the substrate.

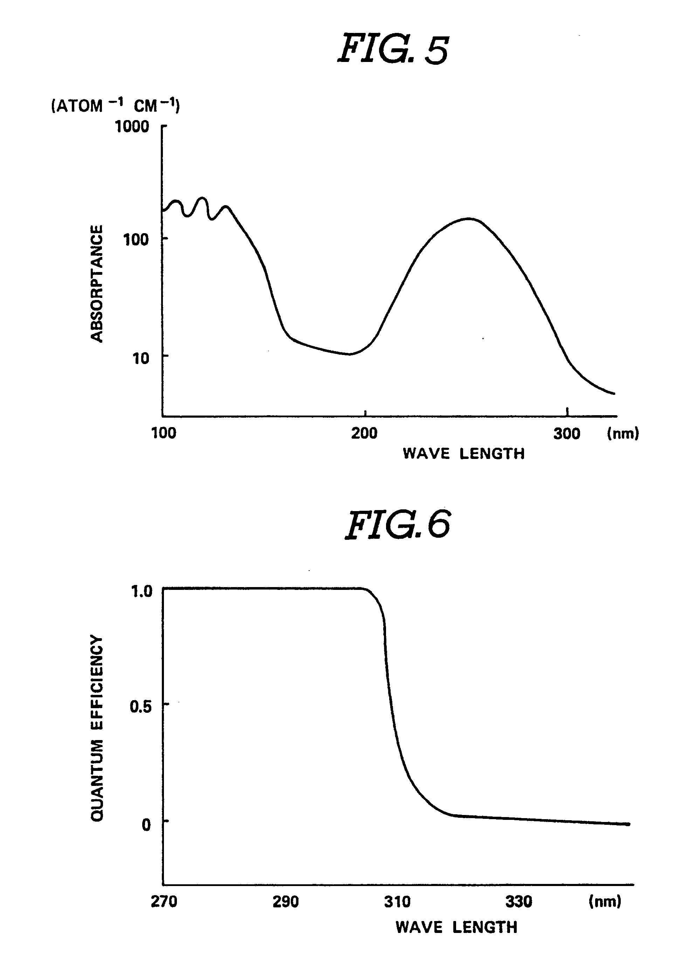

Fig. 4 shows the relationship between the kind of gases, i.e. $O_2$, $N_2O$, $NO_2$ and $O_3$ and the corresponding energy beam wavelength needed to generate excited oxygen $O^*$. As seen from Fig. 5, photolysis is induced in $NO_2$ gas at energy beam wavelengths equal to or less than 244 nm, in $N_2O$ gas at wavelengths equal to or less then 230 nm, and in $O_2$ at wavelength equal to or less than 175 nm. For inducing photolysis of $O_3$, not only the foregoing XeCl excimer laser, but also KrF excimer lasers, low-pressure mercury lamps, and heavy hydrogen lamps can be used.

Also, a XeF excimer laser unit and a KrF excimer laser unit may be employed. The XeF excimer laser unit generates a XeF excimer laser beam of 350 nm wavelength. The KrF excimer laser unit generates a KrF excimer laser beam of 249 nm wavelength.

The XeF excimer laser beam heats the surface of the silicon substrate 12 under an atmosphere of $O_3/O_2$ mixture which is 0.5 atm ($50 \times 10^6$Pa) of $O_2$ and 0.5 atm ($50 \times 10^6$Pa) of an $O_3/O_2$ mixture including 1% $O_3$ to a temperature equal to or less than 900°C, which is low enough to avoid internal distortion of the silicon substrate.

As set forth above, the KrF excimer laser beam of 249 nm wavelength is suitable for inducing photolysis of the $O_3/O_2$ mixture so as to generate excited oxygen atoms $O^*$.

Therefore, this modification exhibits a silicon oxide layer fabrication efficiency equivalent to that achieved by the second embodiment. In cases, where higher efficiency is necessary, the XeF excimer laser may be replaced with an energy beam with a wavelength equal to or less than 260 nm. Therefore, the KrF excimer laser unit used in the foregoing third embodiment can be used as a replacement for the XeF excimer laser unit 26'.

Figs. 5 and 6 show the photolysis characteristics of the $O_3/O_2$ mixture under the KrF excimer beam. As will be appreciated herefrom, the photo-energy absorptance of the mixture gas has two peaks near wavelengths of 100 nm and approximately 250-260 nm, as shown in Fig. 5. On the other hand, the quantum efficiency is substantially higher in the wavelength range below approximately 310 nm than in the range exceeding 310 nm. In view of this, a KrF excimer laser beam of 249 nm wavelength will be significantly more efficient in generating excited oxygen atoms O*.

If the insulating layer fabricating device needs to be relatively simple, a single excimer laser unit can be used both to for generate excited oxygen atoms O* and to heat the semiconductor substrate. In addition, by selecting an energy beam source with a wavelength equal to or less than 260 nm, the bonds between the atoms making up the substrate may be broken while heating the substrate and generating excited oxygen.

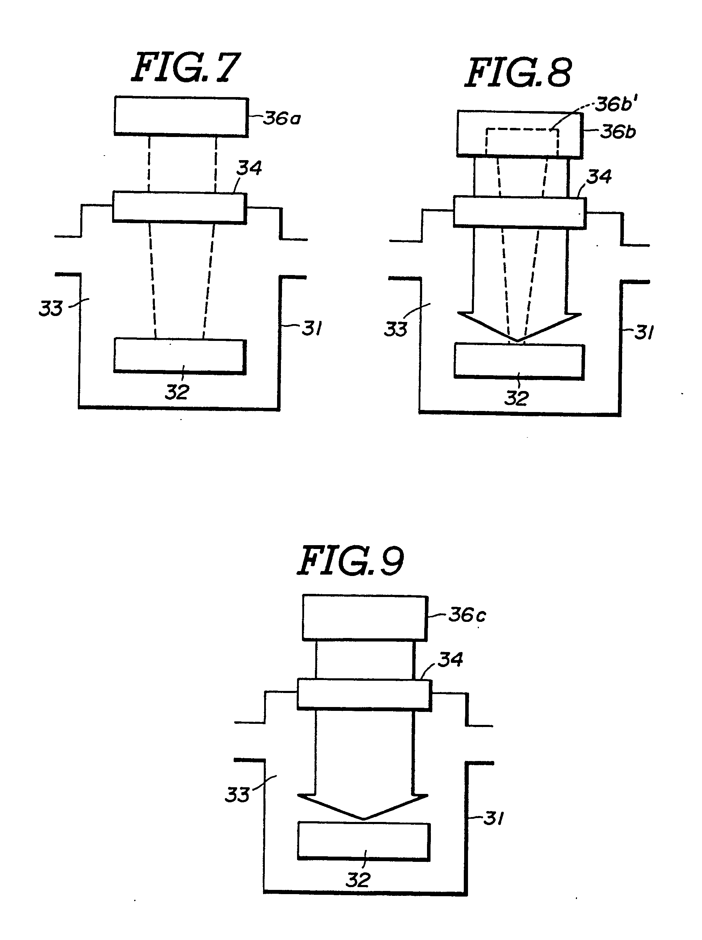

Figs. 7 to 9 show examples of such simplified devices. Fig. 7 shows the first example of a simplified device employing a KrF excimer laser unit 36a as a single energy beam source. The KrF excimer laser beam generated by the KrF excimer laser unit 36a is directed onto a silicon substrate 32 supported in a reaction chamber defined in a housing 31. As in the above embodiments, the reaction chamber 33 is filled with a highly reactive and photolytic gas, such as an $O_3/O_2$ mixture, introduced through an inlet 39.

The KrF excimer laser beam has a wavelength of 249 nm, which is sufficiently short to induce photolysis in the gaseous reagent so as to generate excited oxygen, while also heating the substrate surface and breaking bonds between the silicon atoms. Therefore, the KrF excimer laser beam generates excited oxygen, heats the substrate surface and breaks the bonds between the silicon atoms simultaneously.

Fig. 8 shows the second example, in which the KrF excimer laser unit 36a is replaced with a low-pressure mercury lamp 36b. The energy beam generated by the low-pressure mercury beam has a wavelength of 235 nm. This is sufficiently short to induce photolysis in the gaseous reagent and to break bonds between the silicon atoms. However, as will be appreciated, the energy of the beam generated by the low-pressure mercury lamp 36b is rather low and insufficient to heat the substrate surface, so another energy beam source, such as a XeCl excimer laser unit generating a XeCl excimer laser beam of wavelength 350 nm, is coupled to the low-pressure mercury lamp 36b as an auxiliary energy beam source.

Figs. 9 shows the third example in which a second-order harmonic of at least of a YAG laser beams with a wavelength of 1065 nm is employed. In practice, the fourth-order harmonic of the YAG laser has a wavelength of 226 nm, which is sufficiently short to induce photolysis of the $O_3/O_2$ mixture and so generate excited oxygen atoms. Therefore, the shown third example employs a YAG laser unit 36c which generates the fourth-order harmonic of a YAG laser beam.

Another energy beam source can be combined with the YAG laser unit 36c to generate an energy beam with sufficient energy to heat the surface of the silicon substrate and improve the insulating layer fabrication efficiency. If the energy beam source generates an energy beam with a wavelength equal to or less than 260 nm, bonds between the silicon atoms can be cut to provide even better oxidation efficiency.

## Claims

1. A method of fabricating an insulating oxide layer on a surface of a semiconductor substrate by heating said semiconductor substrate by a first energy beam inside a reaction chamber filled with an oxidizing gas,
**characterized in that**
 – the oxidizing gas filling said reaction chamber contains $O_3$ and $O_2$,
 – and said oxidizing gas is irradiated with light of sufficient photon energy to cause photolysis of $O_3$.

2. A method according to claim 1, **characterized in that** the light from a single laser is used as said first energy beam to heat said semiconductor substrate and as light to be absorbed by $O_3$.

3. A method according to claim 1, **characterized in that** said first energy beam is directed substantially perpendicular to said surface of said semiconductor substrate.

4. A method according to claim 1, **characterized in that** said light to be absorbed by $O_3$ is directed substantially parallel to said surface of said semiconductor substrate.

5. A method according to claim 3, **characterized in that** said first energy beam is selected from among XeCl excimer laser beams, Ar laser beams, XeF excimer laser beams, KrF excimer laser beams, ArF excimer laser beams, ruby laser beams, YAG laser beams, low-pressure mercury lamp light beams, electron beams, or ion beams.

## Patentansprüche

1. Verfahren zur Herstellung einer isolierenden Oxidschicht auf der Oberfläche eines Halbleitersubstrats durch Erwärmen des Halbleitersubstrats mittels eines ersten Energiestrahls innerhalb einer mit einem oxidierenden Gas gefüllten Reaktionskammer,
**dadurch gekennzeichnet, daß**
 – das die Reaktionskammer ausfüllende oxidierende Gas $O_3$ und $O_2$ enthält, und
 – das oxidierende Gas mit Licht ausreichender Photonenenergie bestrahlt wird, um eine Photolyse des $O_3$ zu bewirken.

2. Verfahren nach Anspruch 1, **dadurch gekennzeichnet,** daß das von einem einzigen Laser ausgehende Licht als der erste Energiestrahl zur Erwärmung des Halbleitersubstrats sowie als das durch das $O_3$ zu absorbierende Licht verwendet wird.

3. Verfahren nach Anspruch 1, **dadurch gekennzeichnet,** daß der erste Energiestrahl im wesentlichen senkrecht auf die Oberfläche des Halbleitersubstrats gerichtet wird.

4. Verfahren nach Anspruch 1, **dadurch gekennzeichnet**, daß das durch das $O_3$ zu absorbierende Licht im wesentlichen parallel zur Oberfläche des Halbleitersubstrats ausgerichtet wird.

5. Verfahren nach Anspruch 3, **dadurch gekennzeichnet**, daß der erste Energiestrahl aus der Gruppe von XeCl-Excimer-Laserstrahlen. Ar-Laserstrahlen, XeF-Excimer-Laserstrahlen, KrF-Excimer-Laserstrahlen, ArF-Excimer-Laserstrahlen, Rubin-Laserstrahlen, YAG-Laserstrahlen, Lichtstrahlen einer Niederdruck-Quecksilberdampflampe, Elektronenstrahlen oder Ionenstrahlen ausgewählt wird.

## Revendications

1. Une méthode de fabrication d'une couche d'oxyde isolante sur une surface d'un substrat semi-conducteur par chauffage dudit substrat semi-conducteur par un premier faisceau d'énergie à l'intérieur d'une chambre de réaction remplie d'un gaz oxydant, caractérisée en ce que :
   - le gaz oxydant remplissant ladite chambre de réaction contient du $O_3$ et du $O_2$,
   - et ledit gaz oxydant est irradié par de la lumière ayant une énergie phonolique suffisante pour provoquer la photolyse de $O_3$.

2. Une méthode selon la revendication 1, caractérisée en ce que la lumière provenant d'un seul laser est utilisée comme ledit premier faisceau d'énergie pour chauffer ledit substrat semiconducteur et comme lumière pour être absorbée par $O_3$.

3. Une méthode selon la revendication 1, caractérisée en ce que ledit premier faisceau d'énergie est dirigé substantiellement perpendiculairement à ladite surface dudit substrat semiconducteur.

4. Une méthode selon la revendication 1, caractérisée en ce que ladite lumière à absorber par $O_3$ est dirigée substantiellement parallèlement à ladite surface dudit substrat semi-conducteur.

5. Une méthode selon la revendication 3, caractérisée en ce que ledit premier faisceau d'énergie est choisi parmi les suivants : faisceau laser à excimère de XeCl, faisceau laser à Ar, faisceau laser à excimère de XeF, faisceau laser à excimère de KrF, faisceau laser à excimère de ArF, faisceau laser à rubis, faisceau laser à YAG, faisceau de lumière de lampe à mercure à basse pression, faisceau d'électron ou faisceau ionique.

# FIG.1

# FIG.2

...

FIG.3

FIG.4

## *FIG. 5*

(ATOM⁻¹ CM⁻¹)

ABSORPTANCE

WAVE LENGTH

## *FIG.6*

QUANTUM EFFICIENCY

WAVE LENGTH

## FIG.7

36a

34

33

31

32

## FIG.8

36b'
36b

34

33

31

32

## FIG.9

36c

34

33

31

32